# EUROPÄISCHE PATENTSCHRIFT

(11) **EP 1 496 273 B1**
(45) Veröffentlichungstag und Bekanntmachung des Hinweises auf die Patenterteilung: **24.10.2007**
(21) Anmeldenummer: 04015589.7
(22) Anmeldetag: 02.07.2004
(51) Int. Cl.: F16B 41/00

(54) **Arretierung von Bund-Schrauben oder Bund-Muttern an einem Gehäuse**
Locking of flange screws or nuts with collar at a housing
Verrouillage des vis ou des écrous de bride avec un collier à un logement

(30) Priorität: 09.07.2003 DE 10331011; 06.12.2003 DE 10357095
(43) Veröffentlichungstag der Anmeldung: 12.01.2005
(73) Patentinhaber: Hirschmann Electronics GmbH & Co. KG, 72654 Neckartenzlingen (DE)
(72) Erfinder: Zoller, Ortwin, 71155 Altdorf (DE)
(74) Vertreter: Thul, Hermann

(56) Entgegenhaltungen:
- US-A- 4 904 156
- US-A- 5 290 132
- US-A- 5 894 628

## Beschreibung

Die Erfindung bezieht sich auf eine Vorrichtung und ein Verfahren zum Arretieren von Bundmuttern oder Bundschrauben an einem Gehäuse, insbesondere Kunststoffgehäuse, das eine Gehäuseschale und einen weiteren Gehäuseteil aufweist, die zusammen mit einer Leiterplatte ein Gerätemodul bilden, wobei die Bundschrauben oder Bundmuttern nach Ansetzen des Gerätemoduls auf eine Auflage angezogen werden, gemäß den Merkmalen des jeweiligen Oberbegriffes der unabhängigen Patentansprüche.

Es ist allgemein bekannt, in Fahrzeugen verschiedenartige Komponenten durch Verschrauben zu befestigen. Abgesehen von Anwendungen, bei denen das Gerätemodul auf die Auflage mit Hilfe von Schrauben befestigt werden, ist es auch bekannt, Geräte bzw. Gerätemodule mit Hilfe von Muttern an Schrauben oder Gewindestiften zu befestigen.

Dabei tritt allerdings das Problem auf, dass bei der Montage die Gerätemodule und die Schrauben oder Muttern einzeln aus Aufbewahrungskästen entnommen werden müssen, dass die Schrauben oder Muttern entweder von Hand angedreht oder in Werkzeuge bzw. in Nüsse für Außen- oder Innensechskant oder Kreuzschlitz- oder Torxköpfen eingesetzt und dann eingeschraubt werden. Abgesehen von der getrennten Lagerung der Teile besteht das Problem, dass die Muttern oder Schrauben aus den Nüssen fallen, im Fahrzeug wieder gesucht und neu eingesetzt werden müssen.

Die US-A-4 904 156 zeigt eine Vorrichtung zum Arretieren einer Bundschraube an einer Turbinenschaufel. Hierzu ist ein Halteelement 10 vorgesehen, welches so gestaltet, insbesondere gebogen, ist, dass es mit der Montage der Bundschraube an der Turbinenschaufel montiert wird. Aufgrund der Anforderungen an Turbinenschaufeln ist es selbstverständlich, dass alle beteiligten Bauelemente, also die Turbinenschaufel, die Bundschraube sowie das Halteelement, aus einem hochtemperaturbeständigen Metall bestehen, dass kostenintensiv ist. Außerdem dient das Halteelement 10 dem Zweck, zu verhindern, dass sich die Bundschraube nach ihrer Montage an der Turbinenschaufel aufgrund der hohen Belastungen wieder löst. Hierzu weist das Halteelement einen umlaufenden Kragen 21 auf, der auf den Bund 8 der Bundschraube nach ihrer Montage drückt. Damit wird verhindert, dass sich die Bundschraube von der Turbinenschaufel während des Betriebes lösen kann. Nicht erwähnt ist die Möglichkeit, dass das Haltelement 10 eine Vorpositionierung der Bundschraube in Bezug auf die Turbinenschaufel vor der Montage der Bundschraube an der Turbinenschaufel übernimmt. Denn erst nach der Montage der Bundschraube an der Turbinenschaufel entfaltet das Halteelement seine Wirkung, nämlich das es verhindert, das sich die Bundschraube von der Turbinenschaufel wieder löst. Hinweise darauf, dass das Halteelement schon eine Vorpositionierung der Bundschraube vor und während der Montage der Bundschraube an der Turbinenschaufel vornimmt, sind der US-A-4 904 156 nicht zu entnehmen. Außerdem ist das Halteelement ein separates Bauteil, welches nicht an der Turbinenschaufel und somit nicht an einer Gehäuseschale oder einem Gehäuseteil elastisch befestigt ist. Nach seiner Montage liegt es starr an der Turbinenschaufel an und verhindert, dass sich die Bundschraube von der Turbineschaufel lösen kann.

Aus der US-A-5 894 628 ist eine Befestigungsvorrichtung für den Wischerarm eines Scheibenwichers bekannt. Auch hier ist es aufgrund der Umgebungsbedingungen und der wirkenden Kräfte zwangsweise erforderlich, dass die beteiligten Bauelemente aus einem metallischen Werkstoff und nicht aus Kunststoff bestehen. In Figur 8 wird der Wicherarm 8 an einem Bauteil 1 mittels einer Bundmutter 9, 15, 19 befestigt. Vor der Befestigung wird ein als Sicherungsring 10, 36 ausgebildetes Halteelement in eine Ausnehmung 26 des Bauteiles 1 eingesetzt und verhindert zusätzlich, dass sich die Bundmutter während des Betriebes des Scheibenwichers von dem Scheibenwicherarm 8 lösen kann. Außerdem ist auch bei der US-A-5 894 628 dieses Halteelement ein separates Bauteil, welches erst nach der Montage der Bundmutter montiert wird. Das bedeutet, dass die Bundmutter nicht an dem Bauteil 1 elastisch befestigt ist, sondern erst nach der Montage der Bundmutter in der Ausnehmung 26 des Bauteiles 1 eingeklemmt wird.

Es ist daher Aufgabe der Erfindung, ein Verfahren sowie eine Vorrichtung zur Verfügung zu stellen, die den Anbau von Geräten bzw. Gerätemodule an ihre Auflagestellen erleichtert, die Bandmontage vereinfacht und auch die Lagerhaltung bei den OEM's vereinfacht und verbilligt.

Diese Aufgabe der Erfindung ist durch die jeweiligen Merkmale der unabhängigen Patentansprüche gelöst.

Erfindungsgemäß ist vorgesehen, dass an der Gehäuseschale oder am Gehäuseteil Halteelemente elastisch befestigt sind, dass die Halteelemente in Richtung Gehäuseinneres, insbesondere in Richtung der Leiterplatte oder des zu befestigenden Gehäuseteiles oder der Gehäuseschale gebogen und so ausgerichtet sind, dass sie den Bund der Bundschraube oder Bundmutter hintergreifen.

Aufgrund dieser Ausgestaltung der Halteelemente, kann die Schraube oder Mutter mittels eines Werkzeuges, aber auch von Hand, an die Gehäuseschale oder das Gehäuseteil angesetzt und soweit eingedrückt werden, bis die Halteelemente den Bund der Schraube oder Mutter hintergreifen und diese an der Gehäuseschale oder dem Gehäuseteil fixieren.

Durch diese Ausgestaltung der Erfindung, insbesondere der Halteelemente, wird die Bundschraube oder Bundmutter in vorteilhafter Weise fest arretiert, so dass diese bereits beim Herstellen des Gerätemoduls oder auch vor der Montage in das Gerätemodul eingesetzt werden können und Bestandteil des Moduls sind, so dass bei der Montage nur das Modul angesetzt zu werden braucht und die Schrauben oder Muttern mit entsprechenden Werkzeugen ein- oder aufgedreht werden.

In vorteilhafter Weise wird vorgeschlagen, dass mehrere, vorzugsweise drei Halteelemente über den Umfang der Schrauben oder Muttern verteilt angeordnet sind. Diese Ausgestaltung der Halteelemente ist insbesondere für Muttern von großer Bedeutung, da diese im Gegensatz zu den Schrauben keinen Halt in einer Öffnung des Gerätemoduls haben, sondern nur von den Halteelementen gehalten werden. Dabei ist auch eine möglichst gleichmäßige Verteilung der Halteelemente über den Umfang von Bedeutung und damit ist eine gute Arretierung der Schrauben oder Muttern bei der Befestigung des Gerätemoduls im Fahrzeug möglich.

Damit die Schrauben oder Muttern einen leitenden Kontakt zu der Leiterplatte haben und dadurch die Masse für die Leiterplatte bilden, wird in vorteilhafter Weise vorgeschlagen, dass in Umfangsrichtung der Schrauben oder Muttern gesehen zwischen den Halteelementen Wandteile vorgesehen sind, die eine Raum bilden und von der Gehäuseschale oder dem Gehäuseteil ausgehend in Richtung zur Leiterplatte ausgebildet sind. Dies hat auch den Vorteil, dass die Schraubenköpfe oder Muttern innerhalb der Außenkontur des Gehäusemoduls angeordnet sind. Des weiteren ist dadurch eine zusätzliche Führung der Schrauben oder Muttern gegeben, und das Einsetzen und Eindrücken hinter die Halteelemente wird dadurch vereinfacht.

Um die Elastizität der Halteelemente zu verbessern bzw. sicherzustellen, wird vorgeschlagen, dass zwischen den Halteelementen und den Wandteilen und/oder Gehäuseschalen oder Gehäuseteilen Aussparungen vorgesehen sind. Aufgrund dieser Ausgestaltung der Erfindung grenzen die Wandteile an einen kreiszylindrischen Raum, in den die Halteelemente mit Haltefingern hineinragen.

Die Halteelemente weisen in vorteilhafter Weise im Anschluss an die Haltefinger je einen etwa S-förmigen Wellenbereich auf, in dem die Halteelemente an der Gehäuseschale oder dem Gehäuseteil befestigt sind. Durch diese S-förmige Ausgestaltung der Wellenbereiche im Anschluss an die Haltefinger wird sichergestellt, dass die Haltefinger nicht nur um ihren Anlenkpunkt schwenkbar ausgeführt sind, sondern dass auch die Halteelemente nachgiebig gestaltet sind, so dass insbesondere Nüsse für Außensechskantmuttern problemlos aufgesetzt werden können, ohne dass die Haltefinger bzw. ihre Befestigungsstellen das Ansetzen der Muttern behindern. Auch wird durch den etwa S-förmigen Wellenbereich im Bereich der Haltefinger und Halteelemente ein flexibler Bereich geschaffen, der bei größeren Verformungen bei der Montage des Gerätemoduls im Fahrzeug nicht reißt oder bricht.

Weiterhin ist vorgesehen, dass die Gehäuseschale und das Gehäuseteil miteinander verbunden, insbesondere über ein Filmscharnier miteinander verbunden sind. Auch dies erleichtert die Montage, da nur ein Teil bevorratet und bewegt werden muß. Das Verbinden der beiden Gehäuseteile erfolgt im Falle des Filmscharniers durch einfaches Zusammenklappen, wobei das Filmscharnier schon mit Herstellung der Gehäuseteile vorgesehen wird.

Weiterhin ist vorgesehen, dass die Halteelemente an zumindest einer Stelle eine Wanddickenreduzierung aufweisen. Diese Wanddickenreduzierung, ggfs. alleine oder zusammen mit dem S-förmigen Wellenbereich der Halteelemente, führt zu einer weiteren Verbesserung der Federwirkung der Haltefinger, wobei die Reduzierung mit Herstellung der Halteelemente oder nachträglich eingebracht wird. Je nach Grad der Reduzierung kann die Stärke der Federwirkung eingestellt werden.

Ein Arretieren der Bundschrauben oder Bundmuttern an einem Gehäusemodul und Befestigen des Gehäusemoduls an einer Auflage, insbesondere Auflage einer Karosserie eines Kraftfahrzeuges, erfolgt erfindungsgemäß in vorteilhafter Weise nach den folgenden Schritten.

Zunächst wird das Gerätemodul erstellt. Dann werden die Bundschrauben oder Bundmuttern in die durch die Wandteile und Haltefinger gebildeten Räume eingesetzt. Dann werden die Bundschrauben oder Bundmuttern soweit eingedrückt, bis die Haltefinger hinter den Bünden einrasten. Diese Schritte erfolgen vorteilhafterweise beim Hersteller des Gerätemodells. Auch ist es möglich, die Bundschrauben oder Bundmuttern noch vor dem Aufsetzen des Gehäuseteils auf die Gehäuseschale mit einer Montagevorrichtung auf die Gehäuseschale und die Leiterplatte zu legen und anschließend das Gehäuseteil auf die Gehäuseschale aufzusetzen. Zur Montage des Gerätemoduls im Fahrzeug wird dann das Gerätemodul auf die Auflage aufgesetzt, wobei die Bundschrauben die Öffnungen, z.B. Muttern, an der Auflage erreichen oder die Schrauben oder Gewindestifte durch Öffnungen in der Gehäuseschale oder dem Gehäuseteil und der Leiterplatte ragen und wobei weiter die Bundschrauben oder Bundmuttern gegen die Kraft der Haltefinger von der Leiterplatte weg verschoben werden. Dann werden die Montagewerkzeuge mit entsprechenden Schraubern und Nüssen angesetzt und die Bundschrauben oder Bundmuttern festgedreht, wobei die Nüsse der Werkzeuge die Haltefinger und/oder Halteelemente von den Bundschrauben oder Bundmuttern weg verschieben.

Zur weiteren Erläuterung der Erfindung wird auf die Zeichnungen verwiesen, in denen ein Ausführungsbeispiel der Erfindung, auf das diese jedoch nicht beschränkt ist, dargestellt ist.

Es zeigen:
- Figur 1:: eine perspektivische Ansicht eines Gehäusemoduls mit eingesetzten Bundmuttern,

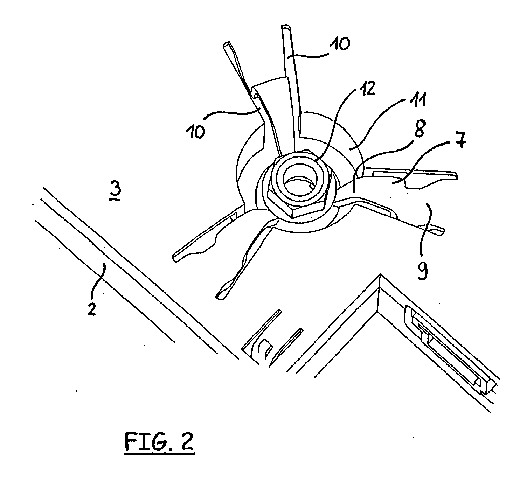

- Figur 2:: ein vergrößerter perspektivischer Ausschnitt des Gerätemoduls nach Figur 1,

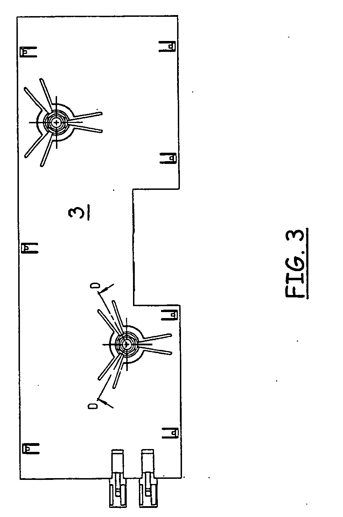

- Figur 3:: eine Draufsicht auf ein Gerätemodul gemäß Figur 1,
- Figur 4:: einen Teilschnitt durch ein Gerätemodul gemäß der Linie D-D in Figur 3,
- Figur 5:: einen Teilschnitt gemäß Figur 4 mit eingesetzter Bundmutter,
- Figur 6:: einen Teilschnitt gemäß Figur 4 mit angesetztem Gerätemodul auf einer Auflage mit angesetzter Werkzeugnuss und
- Figur 7: einen Teilschnitt gemäß Figur 4 mit festgeschraubter Bundmutter.

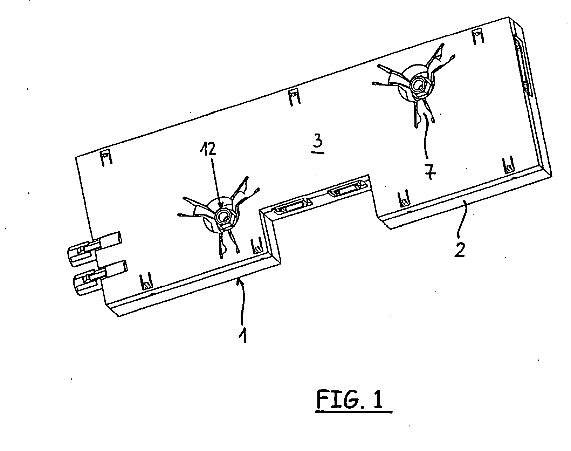

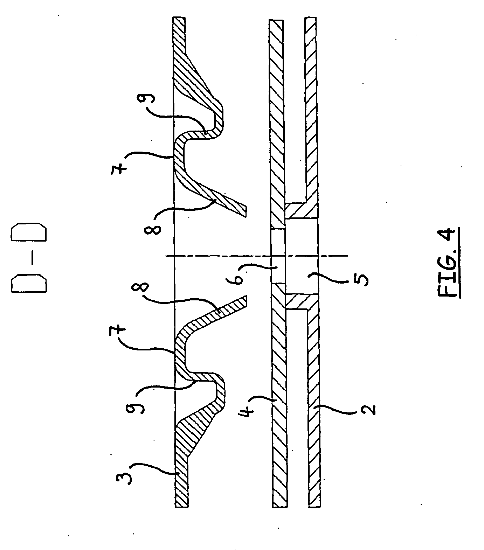

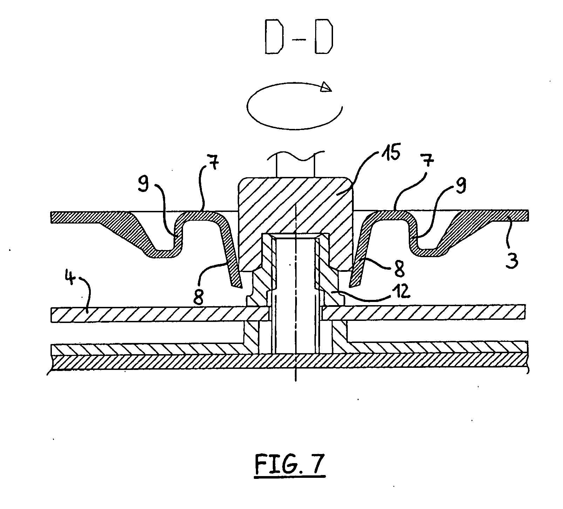

In den Figuren 1 und 7 ist, soweit im einzelnen dargestellt, mit 1 ein Gerätemodul bezeichnet, das eine Gehäuseschale 2, ein Gehäuseteil 3 und, in Figur 4 zu erkennen, eine Leiterplatte 4 aufweist. Die Gehäuseschale 2, das Gehäuseteil 3 und die Leiterplatte 4 sind mittels nicht dargestellter Befestigungselemente miteinander verbunden.

An den vorgesehenen Anschraubstellen des Gerätemoduls 1 sind in der Gehäuseschale 2 Ausnehmungen 5 vorgesehen, an die sich Öffnungen 6 in der Leiterplatte 4 anschließen. In der Gehäuseschale 2 schließen sich an die Ausnehmungen 5 ringartige Vorsprünge an, die die Leiterplatte 4 bei angezogenen Schrauben oder Muttern abstützen.

In Verlängerung der Ausnehmungen 5 und der Öffnungen 6 sind in dem Gehäuseteil 3 Halteelemente 7 vorgesehen, die einen Haltefinger 8 und daran anschließend einen S-förmigen Wellenbereich 9 aufweisen. Die Haltefinger 8 und die S-förmigen Wellenbereiche 9 sind mittels Aussparungen 10 vom Gehäuseteil 3 getrennt, so dass sowohl die Haltefinger 8 als auch der S-förmige Wellenbereich 9 elastisch nachgiebig verformbar ist. Lediglich die dem Haltefinger 8 abgewandten Enden des S-förmigen Wellenbereichs 9 sind mit dem Gehäuseteil 3 verbunden. Zwischen den Halteelementen 7 weist das Gehäuseteil 3 in Umfangsrichtung Ausbuchtungen auf, an die sich Wandteile 11 anschließen, die in Richtung Leiterplatte 4 ausgerichtet sind.

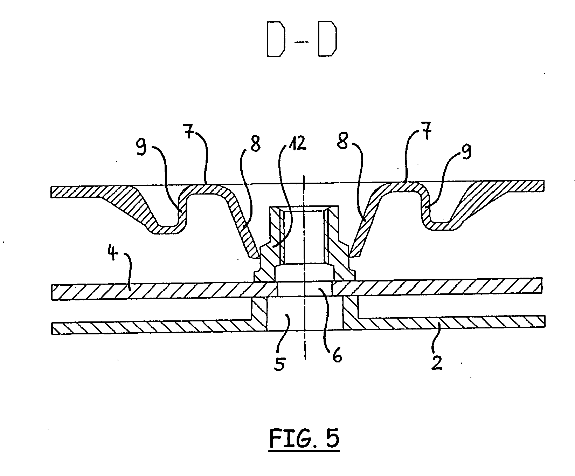

In einer Ausbuchtung des Gehäuseteils 3 gemäß Ausgestaltung nach Figur 4 wird eine Bundmutter 12 eingesetzt und soweit in Richtung Leiterplatte 4 gedrückt, bis die Haltefinger 8 hinter den Bund der Bundmuttern 12 einrasten. Die Bundmutter hat dann eine Position gemäß Figur 5.

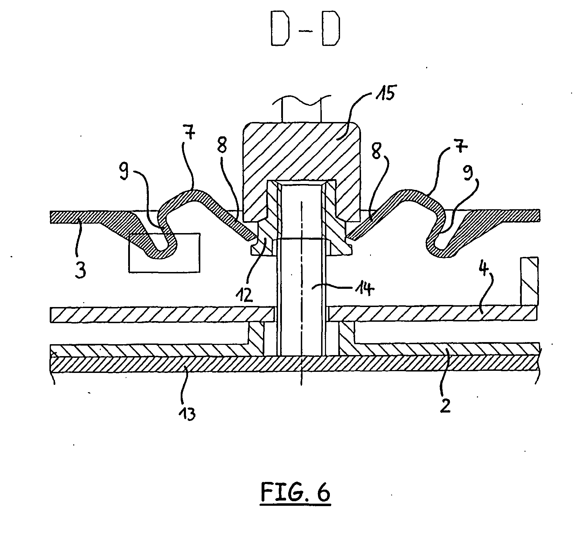

Beim Einbau des Gerätemoduls im Fahrzeug wird das Gerätemodul 1 auf eine Auflage 13 angesetzt, an der Gewindestifte 14 befestigt sind. Durch einen Gewindestift wird dann gemäß Figur 6 die Bundmutter 12 angehoben, die ihrerseits die Haltefinger 8 und die gesamten Halteelemente 7 mit anhebt. Nach Ansetzen einer Werkzeugnuss 15, siehe Figur 6, wird die Bundmutter 12 festgezogen, wobei die Werkzeugnuss 15 die Haltefinger 8 erreicht und diese radial wegschiebt (s. Figur 7).

### Bezugszeichenliste

- 1: Gehäusemodul
- 2: Gehäuseschale
- 3: Gehäuseteil
- 4: Leiterplatte
- 5: Ausnehmung
- 6: Öffnung
- 7: Halteelement
- 8: Haltefinger
- 9: S-förmiger Wellenbereich
- 10: Aussparung
- 11: Wandteil
- 12: Bundmutter
- 13: Auflage
- 14: Gewindestift
- 15: Werkzeugnuss

## Patentansprüche

1. Gehäuse (1) aus Kunststoff, das eine Gehäuseschale (2) und einen weiteren Gehäuseteil (3) aufweist, die zusammen insbesondere mit einer Leiterplatte (4) ein Gerätemodul bilden, wobei Bundschrauben oder Bundmuttern (12) nach Ansetzen des Gehäuses (1) auf eine Auflage (13) angezogen werden, **dadurch gekennzeichnet, dass** an der Gehäuseschale (2) oder am Gehäuseteil (3) Halteelemente (7) elastisch befestigt sind, dass die Halteelemente (7) in Richtung Gehäuseinneres, insbesondere in Richtung der Leiterplatte (4) oder des zu befestigenden Gehäuseteiles (3) oder der Gehäuseschale (2), gebogen und so ausgerichtet sind, dass sie den Bund der Bundschraube oder Bundmutter (12) hintergreifen und die Bundschraube oder Bundmutter (12) vor und während der Montage in ihrer Sollposition zu der Gehäuseschale (2) oder dem Gehäuseteil (3) halten.

2. Gehäuse (1) nach Anspruch 1, **dadurch gekennzeichnet, dass** mehrere, vorzugsweise drei Halteelemente (7) über den Umfang der Bundschraube oder Bundmutter (12) verteilt angeordnet sind.

3. Gehäuse (1) nach einem der Ansprüche 1 oder 2, **dadurch gekennzeichnet, dass** in Umfangsrichtung der Bundschraube oder Bundmutter (12) gesehen zwischen den Halteelementen (7) Wandteile (11) vorgesehen sind, die von der Gehäuseschale (2) oder vom Gehäuseteil (3) ausgehend in Richtung zur Leiterplatte (4) ausgerichtet sind.

4. Gehäuse (1) nach einem der vorhergehenden Ansprüche, **dadurch gekennzeichnet, dass** zwischen den Halteelementen (7) und den Wandteilen (11) und/oder der Gehäuseschale (2) oder dem Gehäuseteil (3) Aussparungen (10) vorgesehen sind.

5. Gehäuse (1) nach einem der vorhergehenden Ansprüche, **dadurch gekennzeichnet, dass** die Wandteile (11) einen vorzugsweise kreiszylindrischen Raum begrenzen, in den die Halteelemente (7) mit Haltefingern (8) hineinragen.

6. Gehäuse (1) nach einem der vorhergehenden Ansprüche, **dadurch gekennzeichnet, dass** die Halteelemente (7) im Anschluss an die Haltefinger (8) je einen etwa S-förmigen Wellenbereich (9) aufweisen, mit dem die Halteelemente (7) an der Gehäuseschale (2) oder am Gehäuseteil (3) befestigt sind.

7. Gehäuse (1) nach einem der vorhergehenden Ansprüche, **dadurch gekennzeichnet, dass** die Gehäuseschale (2) und das Gehäuseteil (3) miteinander verbunden, insbesondere über ein Filmscharnier miteinander verbunden sind.

8. Gehäuse (1) nach einem der vorhergehenden Ansprüche, **dadurch gekennzeichnet, dass** die Halteelemente (7) an zumindest einer Stelle eine Wanddickenreduzierung aufweisen.

9. Verfahren zum Arretieren von Bundschrauben oder Bundmuttern (12) an einem Gehäuse (1) nach einem der Ansprüche 1 bis 8 und Befestigen des Gehäuses (1) an einer Auflage (13), insbesondere Auflage einer Karosserie eines Kraftfahrzeuges, **gekennzeichnet durch** folgende Schritte:
- Erstellen des Gehäuses (1),
- Einsetzen der Bundschrauben oder Bundmuttern (12) in die **durch** die Wandteile (11) und Haltefinger (8) gebildeten Räume,
- Eindrücken der Bundschrauben oder Bundmuttern (12) in die Räume bis die Haltefinger (8) hinter den Bünden einrasten,
- Ansetzen des Gehäuses (1) auf die Auflage (13), wobei die Bundschrauben Anschraubstellen in der Auflage, z.B. Muttern treffen oder die Schrauben oder Gewindestifte (14) **durch** Öffnungen (6) in der Gehäuseschale (2) oder dem Gehäuseteil (3) und der Leiterplatte (4) ragen und wobei die Bundschrauben oder die Bundmuttern (12) die Haltefinger (8) von der Leiterplatte (4) weg verschieben,
- Ansetzen eines Montagewerkzeuges mit Schraubereinsätzen oder Werkzeugnüssen (15) und
- Festdrehen der Bundschrauben oder Bundmuttern (12), wobei die Werkzeugnüsse (15) der Schrauber die Haltefinger (8) und/oder Halteelemente (7) von den Bundschrauben oder Bundmuttern (12) weg verschieben.

10. Verfahren zum Arretieren von Bundschrauben oder Bundmuttern (12) an einem Gehäuse (1) nach einem der Ansprüche 1 bis 8 und Befestigen des Gehäuses (1) an einer Auflage (13), insbesondere Auflage einer Karosserie eines Kraftfahrzeuges, **gekennzeichnet durch** folgende Schritte:
- Einsetzen der Bundschraube oder Bundmutter (12) in die Gehäuseschale (2) oder das Gehäuseteil (3) mit oder ohne einer Leiterplatte (4) mit Hilfe einer Montagevorrichtung,
- Anschließendes Aufsetzen des Gehäuseteiles (3) oder der Gehäuseschale (2) darauf,
- Eindrücken der Bundschrauben oder Bundmuttern (12) in die Räume bis die Haltefinger (8) hinter den Bünden einrasten,
- Ansetzen des Gehäuses (1) auf die Auflage (13), wobei die Bundschrauben Anschraubstellen in der Auflage, z.B. Muttern treffen oder die Schrauben oder Gewindestifte (14) **durch** Öffnungen (6) in der Gehäuseschale (2) oder dem Gehäuseteil (3) und der Leiterplatte (4) ragen und wobei die Bundschrauben oder die Bundmuttern (12) die Haltefinger (8) von der Leiterplatte (4) weg verschieben, ohne dass das Halten der Bundscvhrauben oder der Bundmuttern (12) **durch** die Haltefinger (8) aufgehoben wird,
- Ansetzen eines Montagewerkzeuges mit Schraubereinsätzen oder Werkzeugnüssen (15) und
- Festdrehen der Bundschrauben oder Bundmuttern (12), wobei die Werkzeugnüsse (15) der Schrauber die Haltefinger (8) und/oder Halteelemente (7) von den Bundschrauben oder Bundmuttern (12) weg verschieben.

## Claims

1. Plastic housing (1) which has a housing shell (2) and a further housing part (3) which together in particular with a printed circuit board (4) form an appliance module, collar screws or collar nuts (12) being tightened after attaching the housing (1) to a supporting surface (13), **characterized in that** retaining elements (7) are elastically fastened to the housing shell (2) or the housing part (3), **in that** the retaining elements (7) are bent in the direction of the housing interior, in particular in the direction of the printed circuit board (4) or of the housing part (3) to be fastened or of the housing shell (2), and are oriented in such a way that they engage behind the collar of the collar screw or collar nut (12) and retain the collar screw or collar nut (12) before and during the fitting in its desired position relative to the housing shell (2) or the housing part (3).

2. Housing (1) according to Claim 1, **characterized in that** a plurality of retaining elements (7), preferably three retaining elements (7), are arranged in a distributed manner over the circumference of the collar screw or collar nut (12).

3. Housing (1) according to either of Claims 1 and 2, **characterized in that** wall parts (11) are provided between the retaining elements (7) as viewed in the circumferential direction of the collar screw or collar nut (12), which wall parts (11), starting from the housing shell (2) or the housing part (3), are oriented in the direction of the printed circuit board (4).

4. Housing (1) according to one of the preceding claims, **characterized in that** apertures (10) are provided between the retaining elements (7) and the wall parts (11) and/or the housing shell (2) or the housing part (3).

5. Housing (1) according to one of the preceding claims, **characterized in that** the wall parts (11) define a preferably circular-cylindrical space into which the retaining elements (7) project with retaining fingers (8).

6. Housing (1) according to one of the preceding claims, **characterized in that** the retaining elements (7), following the retaining fingers (8), each have an approximately S-shaped wavy region (9) with which the retaining elements (7) are fastened to the housing shell (2) or the housing part (3).

7. Housing (1) according to one of the preceding claims, **characterized in that** the housing shell (2) and the housing part (3) are connected to one another, in particular via a film hinge.

8. Housing (1) according to one of the preceding claims, **characterized in that** the retaining elements (7) have a reduction in wall thickness at least at one location.

9. Method of locking collar screws or collar nuts (12) on a housing (1) according to one of Claims 1 to 8 and of fastening the housing (1) to a supporting surface (13), in particular a supporting surface of a body of a motor vehicle, **characterized by** the following steps:
- producing the housing (1),
- inserting the collar screws or collar nuts (12) into the spaces formed by the wall parts (11) and retaining fingers (8),
- pressing the collar screws or collar nuts (12) into the spaces until the retaining fingers (8) latch in place behind the collars,
- attaching the housing (1) to the supporting surface (13), the collar screws encountering screw-on locations in the supporting surface, e.g. nuts, or the screws or headless set screws (14) projecting through openings (6) in the housing shell (2) or the housing part (3) and the printed circuit board (4), and the collar screws or the collar nuts (12) pushing the retaining fingers (8) away from the printed circuit board (4),
- applying an assembly tool having screwdriver bits or tool sockets (15), and
- screwing down the collar screws or collar nuts (12), the tool sockets (15) of the screwdrivers pushing the retaining fingers (8) and/or retaining elements (7) away from the collar screws or collar nuts (12).

10. Method of locking collar screws or collar nuts (12) on a housing (1) according to one of Claims 1 to 8 and of fastening the housing (1) to a supporting surface (13), in particular a supporting surface of a body of a motor vehicle, **characterized by** the following steps:
- inserting the collar screw or collar nut (12) into the housing shell (2) or the housing part (3) with or without a printed circuit board (4) by means of an assembly device,
- subsequently mounting the housing part (3) or the housing shell (2) thereon,
- pressing the collar screws or collar nuts (12) into the spaces until the retaining fingers (8) latch in place behind the collars,
- attaching the housing (1) to the supporting surface (13), the collar screws encountering screw-on locations in the supporting surface, e.g. nuts, or the screws or headless set screws (14) projecting through openings (6) in the housing shell (2) or the housing part (3) and the printed circuit board (4), and the collar screws or the collar nuts (12) pushing the retaining fingers (8) away from the printed circuit board (4) without the retention of the collar screws or of the collar nuts (12) by the retaining fingers (8) being neutralized,
- applying an assembly tool having screwdriver bits or tool sockets (15), and
- screwing down the collar screws or collar nuts (12), the tool sockets (15) of the screwdrivers pushing the retaining fingers (8) and/or retaining elements (7) away from the collar screws or collar nuts (12).

## Revendications

1. Boîtier (1) en matière plastique, qui comprend une coque de boîtier (1) et une autre partie de boîtier (2), qui forment un module d'appareil en particulier avec une plaquette de circuits imprimés (4), dans lequel des vis à collier ou des écrous à collier (12) sont serrés après la pose du boîtier (1) sur un support (13), **caractérisé en ce que** des éléments de maintien (7) sont fixés élastiquement sur la coque de boîtier (2) ou sur la partie de boîtier (3), **en ce que** les éléments de maintien (7) sont courbés en direction de l'intérieur du boîtier, en particulier en direction de la plaquette de circuits imprimés (4) ou de la partie de boîtier à fixer (3) ou de la coque de boîtier (2), et sont orientés de telle manière qu'ils s'accrochent à l'arrière de la vis à collier ou de l'écrou à collier (12) et qu'ils maintiennent la vis à collier ou l'écrou à collier (12), avant et pendant le montage, dans leur position définie par rapport à la coque de boîtier (2) ou à la partie de boîtier (3).

2. Boîtier (1) selon la revendication 1, **caractérisé en ce que** plusieurs, de préférence trois éléments de maintien (7) sont repartis sur la périphérie de la vis à collier ou de l'écrou à collier (12).

3. Boîtier (1) selon l'une quelconque des revendications 1 ou 2, **caractérisé en ce que**, vu dans la direction périphérique de la vis à collier ou de l'écrou à collier (12), il est prévu entre les éléments de maintien (7) des parties de paroi (11), qui sont orientées en direction de la plaquette de circuits imprimés (4) à partir de la coque de boîtier (2) ou de la partie de boîtier (3).

4. Boîtier (1) selon l'une quelconque des revendications précédentes, **caractérisé en ce qu'**il est prévu des évidements (10) entre les éléments de maintien (7) et les parties de paroi (11) et/ou la coque de boîtier (2) ou la partie de boîtier (3).

5. Boîtier (1) selon l'une quelconque des revendications précédentes, **caractérisé en ce que** les parties de paroi (11) délimitent un espace de préférence cylindrique rond, dans lequel les éléments de maintien (7) pénètrent avec des doigts de maintien (8).

6. Boîtier (1) selon l'une quelconque des revendications précédentes, **caractérisé en ce que** les éléments de maintien (7) présentent chacun, à la suite des doigts de maintien (8), une zone ondulée sensiblement en forme de S (9), avec laquelle les éléments de maintien (7) sont fixés à la coque de boîtier (2) ou à la partie de boîtier (3).

7. Boîtier (1) selon l'une quelconque des revendications précédentes, **caractérisé en ce que** la coque de boîtier (2) et la partie de boîtier (3) sont reliées l'une à l'autre, en particulier sont reliées l'une à l'autre par une charnière pelliculaire.

8. Boîtier (1) selon l'une quelconque des revendications précédentes, **caractérisé en ce que** les éléments de maintien (7) présentent en au moins un endroit une diminution de l'épaisseur de paroi.

9. Procédé de verrouillage de vis à collier ou d'écrous à collier (12) sur un boîtier (1) selon l'une quelconque des revendications 1 à 8, et de fixation du boîtier (1) sur un support (13), en particulier un support d'une carrosserie d'un véhicule automobile, **caractérisé par** les étapes suivantes:
- construction du boîtier (1);
- introduction des vis à collier ou des écrous à collier (12) dans les espaces formés par les parties de paroi (11) et les doigts de maintien (8);
- enfoncement des vis à collier ou des écrous à collier (12) dans les espaces jusqu'à ce que les doigts de maintien (8) s'accrochent derrière les colliers;
- pose du boîtier (1) sur le support (13), les vis à collier atteignant des points de vissage dans le support, par exemple des écrous, ou les vis ou des tiges filetées (14) traversant des ouvertures (6) dans la coque de boîtier (2) ou dans la partie de boîtier (3) et dans la plaquette de circuits imprimés (4) et les vis à collier ou les écrous à collier (12) écartant les doigts de maintien (8) de la plaquette de circuits imprimés (4);
- application d'un outil de montage avec des têtes de tournevis ou des noix d'outils (15); et
- serrage des vis à collier ou des écrous à collier (12), les noix d'outil (15) des tournevis écartant les doigts de maintien (8) et/ou les éléments de maintien (7) des vis à collier ou des écrous à collier (12).

10. Procédé de verrouillage de vis à collier ou d'écrous à collier (12) sur un boîtier (1) selon l'une quelconque des revendications 1 à 8, et de fixation du boîtier (1) sur un support (13), en particulier un support d'une carrosserie d'un véhicule automobile, **caractérisé par** les étapes suivantes:
- introduction de la vis à collier ou de l'écrou à collier (12) dans la coque de boîtier (2) ou dans la partie de boîtier (3) avec ou sans plaquette de circuits imprimés (4), à l'aide d'un dispositif de montage:
- ensuite pose de la partie de boîtier (3) ou de la coque de boîtier (2) sur celle-ci;
- enfoncement des vis à collier ou des écrous à collier (12) dans les espaces jusqu'à ce que les doigts de maintien (8) s'accrochent derrière les colliers;
- pose du boîtier (1) sur le support (13), les vis à collier atteignant des points de vissage dans le support, par exemple des écrous, ou les vis ou des tiges filetées (14) traversant des ouvertures (6) dans la coque de boîtier (2) ou dans la partie de boîtier (3) et dans la plaquette de circuits imprimés (4) et les vis à collier ou les écrous à collier (12) écartant les doigts de maintien (8) de la plaquette de circuits imprimés (4), sans que le maintien des vis à collier ou des écrous à collier (12) par les doigts de maintien (8) soit supprimé;
- application d'un outil de montage avec des têtes de tournevis ou des noix d'outils (15); et
- serrage des vis à collier ou des écrous à collier (12), les noix d'outil (15) des tournevis écartant les doigts de maintien (8) et/ou les éléments de maintien (7) des vis à collier ou des écrous à collier (12).
